Europäisches Patentamt

European Patent Office

Office européen des brevets

(11) Veröffentlichungsnummer: **0 257 531 B1**

## EUROPÄISCHE PATENTSCHRIFT

(45) Veröffentlichungstag der Patentschrift: **22.04.92**

(21) Anmeldenummer: **87111996.2**

(22) Anmeldetag: **18.08.87**

(51) Int. Cl.5: **G02B 6/12**, H01S 3/05

(54) Optische Resonatormatrix.

(30) Priorität: **22.08.86 DE 3628499**

(43) Veröffentlichungstag der Anmeldung:
**02.03.88 Patentblatt 88/09**

(45) Bekanntmachung des Hinweises auf die
Patenterteilung:
**22.04.92 Patentblatt 92/17**

(84) Benannte Vertragsstaaten:
**DE FR GB**

(56) Entgegenhaltungen:
**EP-A- 0 193 852**
**DE-A- 3 021 139**
**GB-A- 2 105 863**

**N.T.Z.-ARCHIV Band 7, Nr. 10, October 1985,
Seiten 259-265, Berlin, D; R. Müller: "The resonator matrix, a new device for optical
communication to handle a system of many
closely spaced carriers."**

**PATENT ABSTRACTS OF JAPAN Band 6, Nr.
59 (P-110)(937), 16 April 1982 & JP - A - 57
00604**

(73) Patentinhaber: **SIEMENS AKTIENGESELL-
SCHAFT
Wittelsbacherplatz 2
W-8000 München 2(DE)**

(72) Erfinder: **Börner, Manfred, Prof. Dr.
Rehweg 24
W-7900 Ulm(DE)**
Erfinder: **Müller, Reinhard, Dipl.-Ing.
Grimminger Strasse 2
W-8070 Ingolstadt(DE)**
Erfinder: **Trommer, Gert, Dr.
Connollystrasse 16
W-8000 München 40(DE)**

**Beschreibung**

Die vorliegende Erfindung betrifft eine Anordnung von optischen Resonatoren nach dem Oberbegriff des Patentanspruchs 1.

Eine Anordnung der genannten Art ist in der älteren europäischen Patentanmeldung EP-A-193 852 (ein Dokument unter Art. 54(3) EPÜ) vorgeschlagen. Bei dieser Anordnung besteht das Material des optischen Wellenleiters mindestens eines Nutzresonators aus einem laserfähigen Material, so daß dieser optische Wellenleiter mit dem im Anspruch 1 der vorliegenden Anmeldung angegebenen Bereich aus laserfähigem Material identisch ist. Das im optischen Wellenleiter angeregte Wellenfeld kann durch Pumpen des laserfähigen Materials verstärkt werden. Beispielsweise wird dazu der aus einem laserfähigen Kristallmaterial bestehende optische Wellenleiter in einem in Durchlaßrichtung betriebenen pn-Übergang angeordnet.

Aufgabe der Erfindung ist es, eine Anordnung der genannten Art anzugeben, bei der im Hinblick auf die optischen Wellenleiter der Nutzresonatoren, deren Wellenfeld durch Pumpen laserfähigen Materials verstärkbar ist, gute wellenleitende Eigenschaften erzielt werden können, die denen guter ungepumpter dielektrischer Wellenleiter entspricht, und die darüber hinaus relativ leicht herstellbar ist.

Diese Aufgabe wird durch die im kennzeichnenden Teil des Patentanspruchs 1 angegebenen Merkmale gelöst.

Die Tatsache, daß bei dieser Lösung der optische Wellenleiter eines Nutzresonators, dessen Wellenfeld durch Pumpen laserfähigen Materials verstärkt werden kann, und der Bereich, der dieses laserfähige Material enthält, voneinander getrennt sind, ermöglicht es, daß für den Wellenleiter ein Material gewählt werden kann, mit dem sehr gute Wellenleiterstrukturen realisierbar sind, wobei das in dem Wellenleiter angeregte Wellenfeld weiterhin verstärkt werden kann. Außerdem ermöglicht diese Trennung von Wellenleiter und Bereich mit laseraktivem Material, daß dieser Bereich außerhalb der Anordnung der Resonatoren oder Resonatormatrix angeordnet werden kann, wodurch eine einfache Herstellung ermöglicht ist.

Bevorzugterweise wird demnach eine erfindungsgemäße Anordnung generell so gestaltet wie es im Anspruch 2 angegeben ist.

Bevorzugte Ausgestaltungen der erfindungsgemäßen Anordnung im Hinblick auf das laserfähige Material und das Pumpen sind in den Ansprüchen 3 bis 7 angegeben.

Im Anspruch 8 ist eine besonders bevorzugte Ausführungsform der erfindungsgemäßen Anordnung angegeben, die eine besonders einfache Herstellung ermöglicht, weil das laserfähige Material lediglich auf die Oberfläche des Substrats aufgebracht werden muß.

Die Ansprüche 9 bis 11 geben bevorzugte Ausgestaltungen dieser Anordnung nach Anspruch 8 an.

Die erfindungsgemäße Anordnung hat den Vorteil, daß innerhalb der Resonatormatrix keine pn-Übergänge zum Pumpen benötigt werden. Sieht man dennoch pn-Übergänge im Bereich der Nutzresonatoren vor, so erhöhen diese den Freiheitsgrad der Resonatorabstimmung durch Ladungsträgerinjektion oder -absaugung. Außerdem ermöglichen sie eine Modulation des Wellenfeldes. Demgemäß ist eine vorteilhafte Ausführungsform der Erfindung so gestaltet, wie es im Anspruch 12 angegeben ist.

Eine erfindungsgemäße Anordnung kann beispielsweise zur Erzeugung eines Trägerwellenrasters oder zur Realisierung eines linearen Laserverstärkers mit räumlich getrennten Kanalverstärkern verwendet werden, der wegen der Schmalbandigkeit rauschärmer als ein normaler linearer Laserverstärker ist.

Ausführungsbeispiele der Erfindung werden anhand der Figuren in der nachfolgenden Beschreibung näher erläutert. Von den Figuren zeigen:

Figur 1    eine perspektivische Darstellung einer Resonatormatrix, bei der auf der Oberfläche, an der die Nutzresonatoren angeordnet sind, eine Schicht aus optisch pumpbarem laserfähigem Material aufgebracht ist,

Figur 2    die Resonatormatrix nach Figur 1 in gleicher Darstellung, bei der jedoch die Schicht aus optisch pumpbarem laserfähigem Material in Form eines Schichtwellenleiters ausgebildet ist, und

Figur 3    die Resonatormatrix nach Figur 1 oder 2, bei der jedoch die Schicht aus laserfähigem Material aus einem Material besteht, in dem in Durchlaßrichtung betreibbare pn-Übergänge ausgebildet sind.

Die Figuren sind nicht maßstäblich.

Bei den dargestellten Ausführungsbeispielen ist jeweils die gleiche Resonatormatrix 20 verwendet. Sie besteht aus den in das Substrat 21 integrierten Resonatoren 22 und 23. Die Koppelresonatoren sind mit 22 und die wellenlängenselektiven Nutzresonatoren mit 23 bezeichnet. Jeder Resonator 22 bzw. 23 besteht aus einem in das Substrat 21 integrierten langgestreckten optischen Wellenleiter 221 bzw. 231, der an seinen Stirnflächen mit einem hochreflektierenden Reflektor 28 bzw. 29 verspiegelt ist. Alle optischen Wellenleiter 221 und 231 verlaufen parallel zueinander. Die Wellenleiter 231 der Nutzresonatoren 23 verlaufen an der Oberfläche 210 des Substrats 21. Die Koppelresonatoren 22 sind unterhalb der Nutzresonatoren 23 angeordnet.

Solche Resonatormatrizen und auch andere sind in der genannten älteren Patentanmeldung EPA 193 852 hinsichtlich ihres Aufbaus, ihrer Herstellung und ihrer Wirkungsweise ausführlich beschrieben.

Die optischen Wellenleiter 221 und 231 bestehen aus nicht laserfähigem Material. Für das Substrat 21 und die Wellenleiter 221 und 231 können Materialien gewählt werden, mit denen optimale Wellenleitereigenschaften erreicht werden.

Auf der Oberfläche 210 ist der schichtförmige Bereich 30 aus optisch pumpbarem laserfähigem Material direkt aufgebracht, der die Oberfläche 210 und damit auch die von den Koppelresonatoren 20 abgekehrten Seiten der optischen Wellenleiter 231 der Nutzresonatoren 23 vollständig abdeckt. Im Hinblick auf eine einfache Herstellung ist dies sehr zweckmäßig.

Das Material des Bereichs 30 kann ein optisch pumpbares laserfähiges Kristallmaterial, beispielsweise Neodym-Yag, sein, das in einem bekannten Epitaxieverfahren aufbringbar ist. Es kann aber auch eine Farbstofflaserflüssigkeit sein, die optisch gepumpt wird und zusätzlich den Vorteil bietet, daß eine Brechzahlanpassung vorgenommen werden kann. Es sei in diesem Zusammenhang darauf hingewiesen, daß bereits aus Optics Letters, Vol. 10, Nr. 11, Nov. 1985, S. 550-552 ein einmodiger Faserringlaser bekannt ist, bei dem ein gekrümmtes und vom Fasermantel befreites Monomodefaserstück zum Zwecke einer Signalverstärkung mit einer optisch pumpbaren Farbstofflaserflüssigkeit in Kontakt gebracht ist.

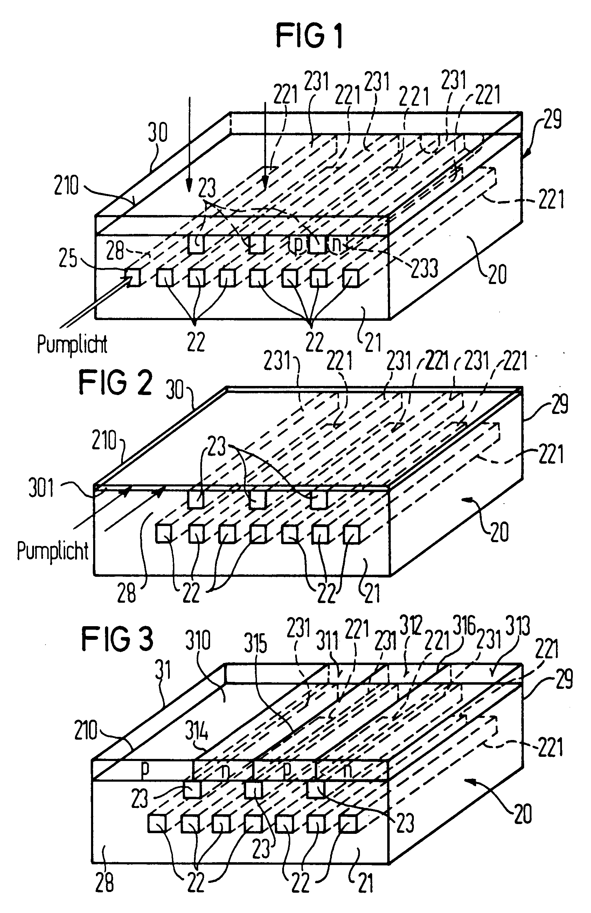

Das Pumplicht kann dem optisch pumpbaren laserfähigen Material durch Belichten des Bereiches 30 von oben zugeführt werden. Es kann aber auch direkt durch einen Einkoppelwellenleiter 25 der Resonatormatrix zugeführt werden, die wegen des bestehenden Resonanzrasters auch für das Pumplicht resoniert und so die Pumpstrahlung bis in den Bereich 30 führt. In der Figur 1 sind beide Zufuhrmöglichkeiten angedeutet, die auch gleichzeitig verwendbar sind.

In der Ausführungsform nach Figur 1 ist der Wellenleiter 231 eines Nutzresonators 23, beispielsweise des in der Darstellung nach Figur 1 rechts außen angeordneten Nutzresonators 23, zwischen zwei einander entgegengesetzt dotierten halbleitenden Bereichen 232 und 233 des Substrats angeordnet, von denen jeder beispielsweise streifenförmig ausgebildet ist und sich beispielsweise über die ganze Länge des zugeordneten Wellenleiters 231 erstreckt.

In der Figur 1 ist beispielsweise der links vom Wellenleiter 231 angeordnete dotierte Bereich 232 p-dotiert, der rechts davon angeordnete Bereich 233 n-dotiert. Es könnte auch der Bereich 232 n-dotiert und der Bereich 233 p-dotiert sein.

An diese einander entgegengesetzt dotierten Bereiche 232 und 233 können über nicht dargestellte Kontakte Spannungen angelegt werden, die in Bezug auf einen entsprechenden pn-Übergang, bei dem ein p-dotierter Bereich und ein n-dotierter Bereich aneinandergrenzen, wahlweise in Sperr- oder Durchlaßrichtung gepolt werden können. Dadurch können wahlweise Ladungen aus dem Wellenleiter 231 abgesaugt bzw. in diesen Wellenleiter injiziert werden. Dadurch erhöht sich der Freiheitsgrad der Resonatorabstimmung und außerdem ist eine Modulation des im Wellenleiter 231 angeregten Wellenfeldes ermöglicht.

Vorzugsweise sind die entgegengesetzt dotierten Bereiche 232 und 233 in einem Abstand vom zugeordneten Wellenleiter 231 angeordnet. Sie sollten nicht in den Wellenleiter 231 hineinragen, sondern allenfalls an ihn angrenzen, weil andernfalls die guten wellenleitenden Eigenschaften dieses Wellenleiters gestört werden könnten.

Selbstverständlich kann der Wellenleiter 231 jedes anderen Nutzresonators 23 in gleicher Weise zwischen zwei zugeordneten, einander entgegengesetzt dotierten Bereichen angeordnet werden, so daß für jeden Nutzresonator der Freiheitsgrad der Resonatorabstimmung erhöht und das in seinem Wellenleiter ausgebildete Wellenfeld modulierbar ist.

Wenn bei der weiter unten beschriebenen Ausführungsform nach Figur 3 entgegengesetzt dotierte Bereiche 232 und 233 im vorstehenden Sinne vorgesehen werden sollen, ist es zweckmäßig, zwischen der Oberfläche 210 des Substrats 1 und dem dortigen Bereich 31 aus dem durch einen pn-Übergang pumpbaren laserfähigen Material eine dünne, nicht dargestellte elektrisch isolierende Schicht anzuordnen.

Beim Ausführungsbeispiel nach Figur 2 ist der schichtförmige Bereich 30 aus optisch pumpbarem laserfähigen Material in Form eines Schichtwellenleiters ausgebildet, der die Oberfläche 210 vollständig abdeckt und in den das Pumplicht eingekoppelt wird. Dies kann beispielsweise mit herkömmlichen Prismenkopplern vorgenommen werden, es kann aber auch über eine Stirnseite 301 direkt eingekoppelt werden, beispielsweise aus einer oder mehreren nicht dargestellten zuleitenden Fasern.

Beim Ausführungsbeispiel nach Figur 3 besteht der die Oberfläche 210 abdeckende Bereich 31 aus einem laserfähigen Kristallmaterial, das durch einen pn-Übergang pumpbar ist, beispielsweise aus GaAs oder GaAlAs, das in einem bekannten Epitaxieverfahren aufbringbar ist. Im Ausführungsbeispiel ist jedem Wellenleiter 231 je ein solcher pn-Übergang 314, 315 und 316 zugeordnet, von denen jeder auf oder über dem zugeordneten Wellenleiter 231 in einer zur Oberfläche 210 des Substrats 21 senkrechten und den zugeordneten Wellenleiter 231 enthaltenden Ebene angeordnet ist und sich über die ganze Länge dieses Wellenleiters 231 erstreckt. Die pn-Übergänge 314, 315 und 316 lassen sich einfach herstellen, weil lediglich die links vom Übergang 314, zwischen den Übergängen 314 und 315, zwischen den Übergängen 315 und 316 und rechts vom Übergang 316 liegenden Teilbereiche 310, 311, 312 bzw. 313 abwechselnd p- und n-dotiert und elektrisch kontaktiert zu werden brauchen, wobei die nicht dargestellten elektrischen Kontakte auf der Oberfläche des Bereichs 31 aufgebracht werden können. Im dargestellten Ausführungsbeispiel sind die Teilbereiche 310 und 312 p-dotiert und die Teilbereiche 311 und 313 n-dotiert. Sie könnten auch umkehrt dotiert sein.

Alle dargestellten Ausführungsformen stellen den speziellen Fall dar, bei dem der Bereich 30 oder 31 aus laserfähigem Material direkt an die Wellenleiter 231 und auch an die Oberfläche 210 des Substrats 21 grenzt. Es kann auch ein Abstand zwischen den Wellenleitern 231 und dem Bereich 30 oder 31 aus laserfähigem Material vorhanden sein. Beispielsweise können die Wellenleiter 231 unter der Oberfläche 210 aber nahe bei dieser Oberfläche angeordnet sein. Auch könnten beispielsweise die Wellenleiter 231 an der Oberfläche 210 angeordnet, aber von einer Deckschicht abgedeckt sein, die den Bereich 30 oder 31 aus laserfähigem Material von ihm trennt.

Bei allen Ausführungsformen der Erfindung muß dafür gesorgt werden, daß das in einem Wellenleiter eines Nutzresonators angeregte Wellenfeld, das auch außerhalb des Wellenleiters vorhanden ist und mit zunehmendem Abstand vom Wellenleiter abklingt, so weit in das durch Pumpen erzeugte Inversionsgebiet des Bereichs aus laserfähigem Material hineinreicht, daß es dort verstärkt werden kann. Bei der Ausführungsform nach der Figur 3 bedeutet dies, daß ein bei seinem Betrieb in Durchlaßrichtung ein schichtförmiges Inversionsgebiet bildender pn-Übergang 314, 315 oder 316 ausreichend nahe an dem zugeordneten optischen Wellenleiter 231 angeordnet ist. Das Inversionsgebiet ist das Gebiet des Bereichs 31 aus laserfähigem Material, in dem durch das Pumpen die für die Erzeugung der Laserstrahlung erforderliche Inversion realisiert wird.

**Patentansprüche**

1. Anordnung von optischen Resonatoren (22, 23), die aus langgestreckten optischen Wellenleitern (221, 231) mit an ihren stirnseitigen Enden angeordneten Reflektoren (28, 29) bestehen, bei der alle optischen Resonatoren (22, 23) matrixartig derart auf einem Substrat (21) integriert sind, daß untereinander stark gekoppelte und als Koppelresonatoren wirkende optische Resonatoren (22) vorhanden sind sowie Nutzresonatoren (23), die untereinander und an die Koppelresonatoren im Vergleich zu den starken Kopplungen zwischen den Koppelresonatoren schwach gekoppelt sind und die als wellenlängenselektive Verstärker resonatoren wirken, bei der zumindest ein pumpbarer Bereich (30, 31) aus laserfähigem Material vorhanden ist, bei der der optische Wellenleiter (231) mindestens eines Nutzresonators (23) aus einem nicht laserfähigen Material besteht, und bei der an diesen optischen Wellenleiter (231) der außerhalb dieses Wellenleiters (231) angeordnete Bereich (30, 31) aus laserfähigem Material angrenzt oder so nahe bei diesem Wellenleiter (231) angeordnet ist, daß ein in diesem Wellenleiter (231) angeregtes Wellenfeld in das beim Pumpen sich ausbildende Inversionsgebiet des Bereichs (30, 31) aus laserfähigem Material hineinreicht und dort verstärkbar ist.

2. Anordnung nach Anspruch 1, **dadurch gekennzeichnet,** daß der Bereich (30, 31) aus laserfähigem Material auf einer von den Koppelresonatoren (22) abgekehrten Seite des optischen Wellenleiters (231) des Nutzresonators (23) angeordnet ist.

3. Anordnung nach Anspruch 1 oder 2, **dadurch gekennzeichnet,** daß der Bereich (30) aus laserfähigem Material Farbstofflaserflüssigkeit enthält, die optisch pumpbar ist.

4. Anordnung nach einem der Ansprüche 1 oder 2, **dadurch gekennzeichnet,** daß der Bereich (30) aus laserfähigem Material ein Kristallmaterial enthält, das optisch pumpbar ist.

5. Anordnung nach einem der Ansprüche 1, 2 oder 4, **dadurch gekennzeichnet,** daß der Bereich (31) aus laserfähigem Material ein Kristallmaterial enthält, das durch Licht aus einem in Durchlaßrichtung betriebenen pn-Übergang pumpbar ist.

6. Anordnung nach Anspruch 3 oder 4, **dadurch gekennzeichnet,** daß dem Bereich (30) aus optisch pumpbarem laserfähigem Material Pumplicht von außen zugeführt ist.

7. Anordnung nach Anspruch 3, 4 oder 6, **dadurch gekennzeichnet,** daß ein Einkoppelwellenleiter (25) vorgesehen ist, der das Pumplicht durch einen Einkoppelwellenleiter (25) in die Koppelresonatoren (22) einkoppelt und daß das Pumplicht von dort über einen auf das Pumplicht abgestimmten Nutzresonator (23) dem diesem Nutzresonator benachbarten Bereich (30) aus laserfähigem Material zugeführt wird.

8. Anordnung nach Anspruch 2 und 7, **dadurch gekennzeichnet,** daß die optischen Wellenleiter (231) der Nutzresonatoren (23) an oder nahe der Oberfläche (210) des Substrats angeordnet sind, und daß der Bereich (30, 31) aus dem laserfähigen Material auf dieser Oberfläche (210) aufgebracht ist und die optischen Wellenleiter (231) der Nutzresonatoren (23) ganz oder teilweise abdeckt.

9. Anordnung nach Anspruch 6 und 8, **dadurch gekennzeichnet,** daß das Pumplicht dem abdeckenden Bereich (30) aus optisch pumpbarem laser fähigem Material durch Belichten dieses Bereichs (30) zugeführt ist.

10. Anordnung nach Anspruch 6 und 8, **dadurch gekennzeichnet,** daß der abdeckende Bereich (30) aus optisch pumpbarem laserfähigem Material in Form eines Schichtwellenleiters ausgebildet ist, in den das Pumplicht von außen einkoppelbar ist.

11. Anordnung nach Anspruch 10, **dadurch gekennzeichnet,** daß das Pumplicht über eine Stirnseite des Schichtwellenleiters einkoppelbar ist.

12. Anordnung nach einem der vorhergehenden Ansprüche, **dadurch gekennzeichnet,** daß der optische Wellenleiter (231) zumindest eines Nutzresonators (23) zwischen einander entgegengesetzt dotierten halbleitenden Bereichen (232, 233) des Substrats (1) angeordnet ist.

**Claims**

1. Array of optical resonators (22, 23), which consist of elongate optical waveguides (221, 231) with reflectors (28, 29) disposed at their end faces, in which array all optical resonators (22, 23) are integrated in the manner of a matrix on a substrate (21) in such a manner that optical resonators (22) which are strongly coupled to one another and which act as coupling resonators are present, as well as useful resonators (23), which are coupled to one another and to the coupling resonators weakly in comparison with the strong couplings between the coupling resonators and which act as wavelength-selective amplifier resonators, in which at least one pumpable region (30, 31) consisting of laser-active material is provided, in which the optical waveguide (231) of at least one useful resonator (23) consists of a laser-inactive material, and in which that region (30, 31) which is disposed outside this waveguide (231) and which consists of laser-active material adjoins this optical waveguide (231) or is disposed so close to this waveguide (231) that a wave field excited in this waveguide (231) extends into the inversion region, formed upon pumping, of the region (30, 31) of laser-active material and can be amplified there.

2. Array according to Claim 1, characterised in that the region (30, 31) of laser-active material is disposed on a side of the optical waveguide (231) of the useful resonator (23), which side faces away from the coupling resonators (22).

3. Array according to Claim 1 or 2, characterised in that the region (30) of laser-active material contains dye laser liquid which is optically pumpable.

4. Array according to one of Claims 1 or 2, characterised in that the region (30) of laser-active material contains a crystal material which is optically pumpable.

5. Array according to one of Claims 1, 2 or 4, characterised in that the region (31) of laser-active material contains a crystal material which is pumpable by light from a pn junction operated in the conductive direction.

6. Array according to Claim 3 or 4, characterised in that pumping light is supplied from outside to the region (30) of optically pumpable laser-active material.

7. Array according to Claim 3, 4 or 6, characterised in that a coupling-in waveguide (25) is provided, which couples in the pumping light through a coupling-in waveguide (25) into the coupling resonators (22) and in that the pumping light is supplied from there via a useful resonator (23) tuned to the pumping light to that region (30) of laser-active material which is adjacent to this useful resonator.

8. Array according to Claims 2 and 7, characterised in that the optical waveguides (231) of the useful resonators (23) are disposed at or near the surface (210) of the substrate, and in that the region (30, 31) of the laser-active material is applied on this surface (210) and wholly or partially covers the optical waveguides (231) of the useful resonators (23).

9. Array according to Claims 6 and 8, characterised in that the pumping light is supplied to the covering region (30) of optically pumpable laser-active material by exposure of this region (30).

10. Array according to Claims 6 and 8, characterised in that the covering region (30) of optically pumpable laser-active material is designed in the form of a film waveguide into which the pumping light can be coupled in from outside.

11. Array according to Claim 10, characterised in that the pumping light can be coupled in via an end face of the film waveguide.

12. Array according to one of the preceding claims, characterised in that the optical waveguide (231) of at least one useful resonator (23) is disposed between mutually oppositely doped semiconducting regions (232, 233) of the substrate (1).

**Revendications**

1. Dispositif formé de résonateurs optiques (22,23), qui sont constitués par des guides d'ondes optiques allongés (221,231) possédant des réflecteurs (28,29) situés sur leurs extrémités frontales, et dans lequel les résonateurs optiques (22,23) sont tous intégrés selon une disposition matricielle sur un substrat (21) de manière à former des résonateurs optiques (22) couplés entre eux selon un couplage fort et agissant en tant que résonateurs de couplage, et des résonateurs utiles (23), qui sont couplés selon un couplage faible entre eux et avec les résonateurs de couplage par rapport aux couplages forts existant entre les résonateurs de couplage et agissent en tant que résonateurs amplificateurs sélectifs du point de vue des longueurs d'onde, et dans lequel il est prévu au moins une zone (30,31) pouvant être pompées et formées d'un matériau apte à produire l'effet laser, et dans lequel le guide d'ondes optiques (231) est constitué par au moins un résonateur utile (23) formé d'un matériau non apte à produire l'effet laser, et dans lequel la zone (30,31), qui est disposée à l'extérieur de ce guide d'ondes optiques (231) et réalisée en un matériau apte à produire l'effet laser, jouxte le guide d'ondes optiques (231) ou est disposée de manière à être suffisamment proche de ce guide d'ondes (231) pour qu'un champ d'ondes, excité dans le guide d'ondes optiques (231) pénètre dans la région d'inversion, qui se forme lors du pompage, de la zone (30,31) formée du matériau apte à produire l'effet laser et y est amplifié.

2. Dispositif suivant la revendication 1, caractérisé par le fait que la zone (30,31) formée d'un matériau apte à produire l'effet laser est disposée sur une face, tournée à l'opposé des résonateurs de couplage (22), du guide d'ondes optiques (232) du résonateur utile (23).

3. Dispositif suivant la revendication 2 ou 3, caractérisé par le fait que la zone formée du matériau apte à produire l'effet laser comporte un liquide laser à colorant, qui peut être pompé optiquement.

4. Dispositif suivant l'une des revendications 1 ou 2, caractérisé par le fait que la zone (30) réalisée en un matériau apte à produire l'effet laser comporte un matériau cristallin pouvant être pompé optiquement.

5. Dispositif suivant l'une des revendications 1, 2 ou 4, caractérisé par le fait que la zone (31) formée du matériau apte à produire l'effet laser comporte un matériau cristallin qui peut être pompé par la lumière à partir d'une jonction pn fonctionnant dans le sens passant.

6. Dispositif suivant la revendication 3 ou 4, caractérisé par le fait que la lumière de pompage est amenée de l'extérieur à la zone (30) formée du matériau apte à produire l'effet laser et pouvant être pompée optiquement.

7. Dispositif suivant la revendication 3, 4 ou 6, caractérisé par le fait qu'il est prévu un guide d'ondes d'injection par couplage (25), qui injecte la lumière de pompage au moyen d'un guide d'ondes d'injection par couplage (25) dans les résonateurs de couplage (22) et que la lumière de pompage est envoyée, à partir de là, par l'intermédiaire d'un résonateur utile (23) réglé sur la lumière de pompage, à la zone (30) qui est voisine de ce résonateur utile et est formée d'un matériau apte à produire l'effet laser.

8. Dispositif suivant les revendications 2 et 7, caractérisé par le fait que les guides d'ondes optiques (231) des résonateurs utiles (23) sont disposés sur ou à proximité de la surface (210) du substrat et que la zone (30,31) formée du matériau apte à produire l'effet laser est déposée sur cette surface (210) et recouvre en totalité ou en partie les guides d'ondes optiques (232) des résonateurs utiles (23).

9. Dispositif suivant les revendications 6 et 8, caractérisé par le fait que la lumière de pompage est envoyée à la zone de recouvrement (30) formée d'un matériau apte à produire l'effet laser et pouvant être pompé optiquement, par exposition de cette zone (30).

10. Dispositif suivant les revendications 6 et 8, caractérisé par le fait que la zone de recouvrement (30) formée du matériau apte à produire l'effet laser et pouvant être pompé optiquement est agencée sous la forme d'un guide d'ondes à couches, dans lequel la lumière de pompage peut être injectée de l'extérieur.

11. Dispositif suivant la revendication 10, caractérisé par le fait que la lumière de pompage peut être injectée par l'intermédiaire d'une face frontale du guide d'ondes à couches.

12. Dispositif suivant l'une des revendications précédentes, caractérisé par le fait que le guide d'ondes optiques (231) d'au moins un résonateur utile (23) est disposé entre des régions semiconductrices (232,233) du substrat (1) possédant des dopages réciproquement opposés.

EP 0 257 531 B1

# FIG 1

Pumplicht

# FIG 2

Pumplicht

# FIG 3

8